# EUROPEAN PATENT APPLICATION

(11) **EP 3 974 905 A1**
(43) Date of publication of application: **30.03.2022**
(21) Application number: 20198416.8
(22) Date of filing: 25.09.2020
(51) Int. Cl.: G03F 7/20, H05G 2/00

(54) **PUMP**

(71) Applicant: ASML Netherlands B.V., 5500 AH Veldhoven (NL)
(72) Inventor: DE RAPPER, Willem, Michiel, 5500 AH Veldhoven (NL)
(74) Representative: ASML Netherlands B.V.

(57) **Abstract**

Described is a pump comprising a reservoir and a plurality of heating elements in thermal communication with the reservoir, the plurality of heating elements configured to selectively provide thermal energy to the reservoir. Also described is a method of pumping a material, said method including providing a pump with a reservoir in thermal communication with an array of heating elements; providing the material to be pumped in the reservoir; operating the array of heating elements to melt the material in the reservoir; operating the array of heating elements to allow a first portion of the liquid material to solidify thereby forming a plug; operating the array of heating elements to allow an upstream second portion of the liquid material adjacent to the plug to solidify; and operating the array of heating elements to melt a downstream portion of the plug to generate a portion of liquid material at increased pressure.

## Description

### FIELD

The present invention relates to a pump with particular, but not exclusive, use in connection with a lithographic apparatus, particularly an EUV lithography apparatus. The present invention also relates to a method of pumping a material as well as lithographic apparatuses using such pumps or methods, as well as sub-systems thereof.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Methods for generating EUV light include, but are not limited to, altering the physical state of a source material to a plasma state. The source materials include a compound or an element, for example, xenon, lithium, or tin, with an emission line in the EUV range. In one such method, often termed laser produced plasma ("LPP"), the required plasma is produced by irradiating a source material, for example, in the form of a droplet, stream, or cluster of source material, with an amplified light beam that can be referred to as a drive laser. For this process, the plasma is typically produced in a sealed vessel, for example, a vacuum chamber. Where droplets are used, they are provided via a droplet generator apparatus, which is supplied with high pressure liquid source material.

The apparatus used to provide the high pressure source material is complex and it is desirable to provide a simpler apparatus which still is able to reliably and safely generate high pressure source material for use in the creation of EUV light. It is also desirable to provide a cheaper pumping apparatus that is also inherently safer than existing pumps.

### SUMMARY

According to a first aspect there is provided a pump comprising a reservoir and a plurality of heating elements in thermal communication with the reservoir, the plurality of heating elements configured to selectively provide thermal energy to the reservoir.

The pump is for providing high pressure source material to a lithography apparatus, in particular to a droplet generator apparatus of an EUV lithography apparatus. The reservoir is for retaining a source material which is to be pumped.

In current EUV lithography apparatus, EUV light is generated by supplying laser energy to droplets of tin which are converted into a plasma, which subsequently radiates EUV light. In order to generate the tin droplets, liquid tin under high pressure is provided to a droplet generator system. In existing systems, the liquid tin is pressurized using high pressure gases. Other source material, such as lithium, may be used instead of tin. In particular, the droplet generator requires liquid source material, such as liquid tin, at a pressure of over 25 MPa (250 bar). No existing high pressure pump is able to provide liquid source material, such as tin, at this high pressure and at temperatures above 180°C, for example where the source material is lithium, or above 232°C when the source material is tin, and so single-shot high pressure systems are used. In a single-shot high pressure system, a tank is filled with liquid source material then pressurized with gas, such as argon, and is connected to a droplet generator. Whilst this provides an effective way of generating high pressure tin, there are safety precautions which need to be adhered to due to the use of high-pressure gases. In addition, such systems require the switching of pressure vessels since one is required to be feeding the droplet generator whilst the other is being recharged in order for there to be a continuous supply of source material, such as tin or lithium. Furthermore, such systems require the use of valves which are capable of handling both high pressures and liquid tin or lithium. It is therefore desirable to provide a high pressure pump that does not have the disadvantages of existing pumps and has a simpler construction. The pump according to the present invention does not require the use of high pressure gases and has effectively no moving parts. It has been found that it is possible to generate a pumping effect by selective heating and cooling, instead of by mechanical action of existing pumps, such as through the rotation of impellers, the movement of pistons, or pressurization via gases. By selectively providing thermal energy to the reservoir, it is possible to change the state of source material contained within the reservoir between a liquid and a solid, which results in a change of volume of the material. By controlling the order in which material within the reservoir is melted and solidified, it is possible to generate increased pressures and thereby pump the material.

The pump may include a source material within the reservoir. A source material is one which may be used in a lithography apparatus to generate light of a desired wavelength, such as EUV light. The source material is preferably a solid at standard temperature and pressure. The source material may be selected from tin or lithium. Whilst other source materials, such as xenon, may be used, tin and lithium are both solids at standard atmospheric temperatures and pressure, so are preferred as the mechanism of action of the pump is based on the change in density upon a change of phase of material, in particular, the decrease in density of a material when going from a liquid to a solid, which would be difficult to achieve with gases such as xenon, although not impossible. Whilst reference will be made to tin in the description, it should be appreciated that lithium or other suitable source materials are also expressly contemplated and reference to tin is equally considered as reference to at least lithium and xenon or other suitable materials. Materials which increase in density when going from a solid to a liquid, such as water or bismuth, are not suitable materials.

When solid tin melts, its volume increases by around 3%. This change in volume can be leveraged to create a high pressure pump. By selectively providing thermal energy to the reservoir, it is possible to selectively melt tin within the pump. As such, it is possible to create areas of liquid tin and areas of solid tin within the pump, in particular within the reservoir. The solid tin is able to act like a plug which prevents the liquid tin from expanding in the direction of the solid plug. By melting the liquid tin adjacent to a plug of solid tin, the liquid tin expands in volume relative to when it was in the solid state and a pressure is generated. This pressure can then be used to feed a droplet generator system, which provides an outlet for the pressure generated by the expanding liquid tin since the liquid tin is blocked from moving by the solid plug within the reservoir. As such, the pump does not comprise any moving parts as the pressure is generated by the controlled application of thermal energy to the reservoir of the pump.

The pump may further comprise a controller configured to selectively operate the heating elements in a preselected order. The controller allows the plurality of heating to provide the pump with different pumping characteristics, such as different operating pressures or different volumetric throughputs, but controlling the operation of the heating elements. For example, the order of the heaters being turned on and off can be selected, the length of time each heater is turned on or off can be adjusted, and the temperature to which the heating elements operate can also be adjusted. If the heating elements are activated in the wrong order, there would be no pumping action observed. The controller allows the heating elements to be controlled such that the source material within the pump can be selectively melted. The controller may be programmable. The controller may have multiple operating programmes to alter the pumping characteristics of the pump.

The reservoir may have a diameter change along its length. The reservoir may comprise an inner wall and the inner wall may be threaded, tapered, or tapered and threaded. Since the pump relies on plugs of solid tin to retain the high-pressure generated, in some cases the pressure generated may extrude the solid tin along the reservoir and thereby lose the pressure which has been generated, so providing a diameter change along the length of the reservoir allows the solid plug to be retained more tightly. By threading the inner wall of the reservoir, the solid plug of tin is prevented from being forced along the reservoir. Similarly, by having a tapered reservoir with the wider portion being provided at a high pressure side and the narrower portion being provided at a low pressure side of the solid plug, the tin plug is unable to be forced along the reservoir towards the low pressure side. The reservoir may be tapered and threaded. It will be appreciated that the reservoir could also be formed with discrete cut-outs in the inner wall which provide areas of the reservoir in which the plugs can be formed to again prevent the plugs from being forced along the reservoir.

The pump may comprise a cooling mechanism. Since the pump relies upon the selective heating and cooling, specifically melting and solidification, of material contained therein, it may take an undesirably long time for the material to solidify once heating has ceased if the material is simply allowed to passively cool down. In order to increase the rate at which liquid material cools, the pump may be actively cooled, as opposed to simply relying on radiation or natural convection of the heat away from the pump. The cooling can be carried out by any suitable means and may include, for example, water or oil cooling. The pump may be provided with suitable cooling channels through which coolant may be provided. Tin melts at around 232°C and lithium melts at around 180°C, so any cooling method which is able to cool tin or lithium to below the relevant temperature is suitable.

The pump may comprise a plurality of reservoirs. In order to provide a continuous output of high pressure source material, it may be desirable to provide a plurality of reservoirs each configured to provide high-pressure liquid source material, such as tin or lithium. Any suitable number of reservoirs may be used, and the invention is not particularly limited to the exact number of reservoirs included in the pump. The outputs of the individual reservoirs may be connected to a common manifold. The outputs of the plurality of reservoirs can be connected together to allow there to be a generally continuous output of high pressure material which can be supplied to the lithography apparatus. In other embodiments, the outputs of each reservoir are not connected to a common manifold. A further advantage of having a pump comprising multiple reservoirs is that a more continuous fluid flow can be achieved. In addition, the apparatus may be more resistant to high pressures due to physical scaling laws which mean that relatively thinner walls are required when pumping the same volume of material through multiple reservoirs as opposed to a single large reservoir.

The plurality of heating elements may be in the form of a helix around the reservoir. Preferably, each heating element makes more than one turn around the reservoir. Since the function of the pump takes advantage of the presence of a solid plug of the source material, by having each heating element make more than one turn around the reservoir, it is possible to ensure that there is a solid plug in the or each reservoir by turning off one of the heating elements. Whilst this could also be achieved by having the heating elements radially disposed around the reservoir, this would result in the plug in each reservoir being located at the same distance along each reservoir, which may be less desirable when using a pump with multiple reservoirs since the multiple reservoirs desirably function to provide a continuous flow of high-pressure source material. In contrast, by having helical heating elements, the location of the solid material within each reservoir generally tracks the shape of the helix, thereby locating the solid plug at relatively different locations within each reservoir.

The controller may be configured such that at least one of the heating elements is turned off at any one time during (pumping) operation. Whilst it may be desirable or even necessary to have all of the heating elements turned on at start up or during a cleaning process to allow all of the source material within the pump to be in the liquid state, during operation it is desirable for the or each reservoir to include at least one solid plug along its length. This is for both safety reasons and also to maintain pressure. In order to ensure the presence of at least one solid plug in the or each reservoir during operation, the controller can be programmed to prevent all of the heating elements to be turned on at any one given time. In this way, a portion of each reservoir is below the melting point of the material, which is then able to solidify and form a plug.

The pump may be configured to provide up to 2, up to 5, or up to 10 millilitres per hour of high pressure liquid. Since the pump is intended to be used in a lithographic apparatus, the requirements for the volume of liquid source material is low, with only a few millilitres per hour being required. As such, whilst the pump of the present invention may not be able to displace large volumes of material, this is not necessary for its intended purpose and so relatively small volumes of material need to be pumped.

The pump may be configured to provide liquid at a pressure of at least about 0.1 MPa, at least about 1 MPa, at least about 10 MPa, at least about 25 MPa, at least about 50 Mpa, at least about 70 MPa, at least about 100 MPa, or from around 0.1 MPa to around 200 MPa.

The pump may have a low pressure end in communication with a low pressure reservoir. The low pressure reservoir may include a supply of source material for pumping. The pump may have a high pressure end in communication with a tin droplet generator. Since the pump will be moving the source material from a low pressure end towards a high pressure end, the low pressure end may be connected to a reservoir of the source material in order to replace the material which is expelled from the high pressure end.

According to a second aspect of the present invention, there is provided a method of pumping a material, said method including the steps of:
a) providing a pump with a reservoir in thermal communication with an array of heating elements;
b) providing the material to be pumped in the reservoir;
c) operating the array of heating elements to melt the material in the reservoir;
d) operating the array of heating elements to allow a first portion of the liquid material to solidify thereby forming a plug;
e) operating the array of heating elements to allow an upstream second portion of the liquid material adjacent to the plug to solidify; and
f) operating the array of heating elements to melt a downstream portion of the plug to generate a portion of liquid material at increased pressure.

This method of pumping a material relies on the phase change of a material from a solid to a liquid and the accompanying change in volume. By operating the heating elements in a particular order, it is possible to generate a high pressure liquid that can be fed into a droplet generator apparatus of a lithographic apparatus. By sequentially forming a solid plug and then melting a downstream portion of the plug, the downstream material expands, in the case of tin by around 3%, forcing the liquid towards one end of the reservoir. Since there is a solid plug of material, the liquid is only able to expand in one direction, thereby creating a pumping motion. By repeating this melting and solidifying process in a "caterpillar" motion, it is possible to pump small amounts of material through the reservoir.

The method further including the steps of: g) operating the array of heating elements to allow a third portion of the liquid material upstream of and adjacent to the solidified second portion to solidify; and h) operating the array of heating elements to melt the solidified second portion of the material.

The steps g) and h) may be repeated any number of times such that a continuous flow of material can be created from an upstream (low pressure) end towards a downstream (high pressure) end. It will be appreciated that the process of melting, solidifying and remelting is repeated in an upstream direction until the end of the reservoir is reached, when the process can be restarted from the downstream end once more. It will be appreciated that when the plug reaches the low pressure end of the reservoir, a plug at or towards the high pressure end of the reservoir is desirably formed so that the pressure which has been built up is not released. Although when a plug is formed at the high pressure end, liquid source material will be drawn in from towards the high pressure and low pressure ends and thereby reduce the pressure at the high pressure end, as the process of selective melting and solidifying is repeated along the reservoir, overall there will be a net increase in pressure towards the high pressure end caused by the pumping of the source material. The presence of multiple reservoirs may go some way to addressing this by having multiple reservoirs pumping liquid source material towards the high pressure end whilst one of the reservoirs forms a plug at or towards the high pressure end.

The method may include cooling the reservoir to cool the melted material. Since the method of the present invention relies on cooling and solidification of the material within the reservoir, whilst the melted material may be allowed to cool down without additional cooling provided, this would take a long time and may prove impossible since heat could be transferred to the portion of the metal which is being cooled from the adjacent liquid material. As such, active cooling, such as provided by coolant flowing through coolant channels in the apparatus may be used to more rapidly cool the melted material.

The array of heaters may be controlled with a controller. The controller may be configured to operate the array of heaters in a predetermined order such that the pumping effect is obtained.

The method may further comprise connecting an output of the pump to a droplet generator apparatus. The droplet generator apparatus may be connected to a lithographic apparatus.

According to a third aspect of the present invention, there is provided a sub-system for a lithographic apparatus, said sub-system comprising a droplet generator apparatus and a pump according to the first aspect of the present invention.

The pump according to the first aspect of the present invention is able to generate high pressure liquid which can be fed into the droplet generator. The pump according to the present invention allows the complex systems and apparatus associated with using high-pressure gases to provide the necessary pressures to be completely removed, thus simplifying the apparatus and increasing safety since the use of high-pressure gases can be eliminated.

According to a fourth aspect of the present invention, there is provided a radiation source comprising a pump according to the first aspect of the present invention, a sub-system according to the third aspect of the present invention, or operated in accordance with the method of the second aspect of the present invention.

According to a fifth aspect of the present invention, there is provided a lithographic apparatus comprising a pump according to the first aspect of the present invention, a sub-system according to the third aspect of the present invention, a radiation source according to the fourth aspect of the present invention, or operated in accordance with the method of the second aspect of the present invention.

According to a sixth aspect of the present invention, there is provided the use of a pump, method, sub-system, or lithographic apparatus according to any of the first, second, third, fourth or fifth aspects of the present invention in a lithographic process.

The features described in respect of any of the aspects may be combined with the features described in respect of any of the other aspects of the present invention.

The present invention will now be described with reference to an EUV lithography apparatus. However, it will be appreciated that the present invention is not limited to EUV lithography and may be suitable for other types of lithography.

### BRIEF DESCRIPTION OF THE DRAWINGS

Embodiments of the invention will now be described, by way of example only, with reference to the accompanying schematic drawings, in which:
Figure 1 depicts a lithographic system comprising a lithographic apparatus and a radiation source;
Figure 2 depicts a cross section through a pump according to the present invention;
Figures 3 depicts an exemplary cross-section of a reservoir of the pump according to the present invention;
Figure 4 depicts a series of cross-sections through the pump according to the present invention at different periods of time showing the pumping action of the pump;
Figure 5 depicts a cross section of a pump according to the present invention having multiple reservoirs; and
Figure 6 depicts a side view of a pump according to the first aspect of the present invention showing the heating elements helically wound around the pump.

### DETAILED DESCRIPTION

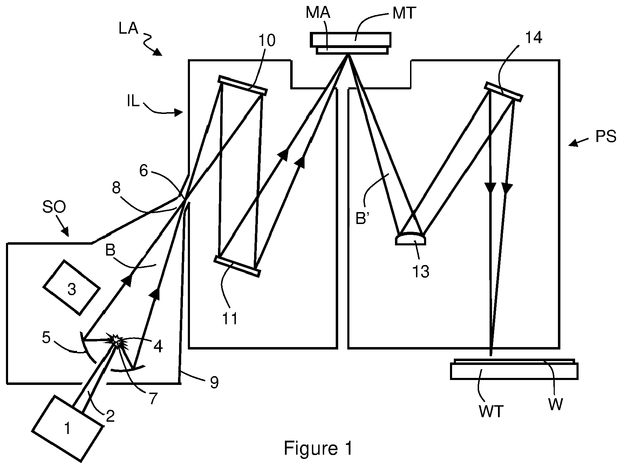

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Fuel emitter 3 may be connected to a droplet generator apparatus. Although tin is referred to in the following description, any suitable fuel may be used. The fuel is in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma. A pump 15 according to the present invention is attached to the fuel emitter 3 and supplies the fuel emitter 3 with a supply of high pressure liquid tin.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

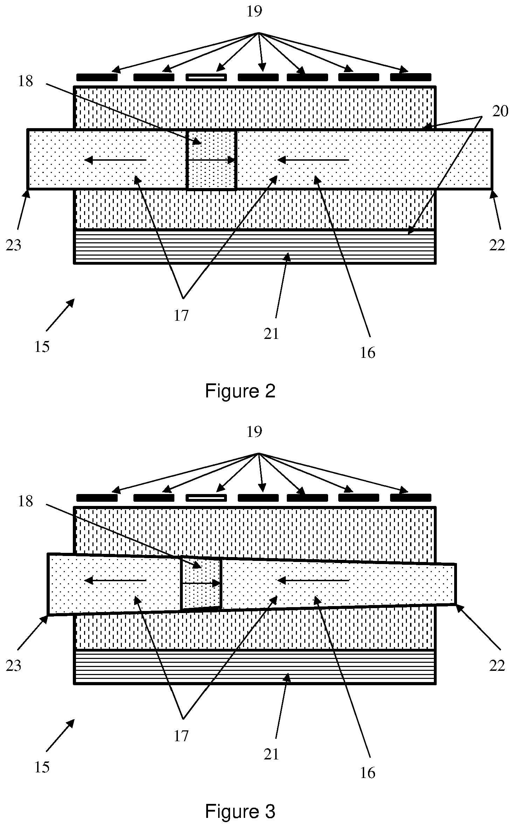

Figure 2 depicts a schematic cross section through the pump 15 according to the first aspect of the present invention. The pump 15 comprises a reservoir 16 which contains the source material, such as tin or lithium. In operation, part of the source material is in liquid form 17 and the remainder of the source material is in the form of a solid plug 18. It will be appreciated that at other times, all of the source material may be liquid, in particular at start-up. At yet other times, the source material may be solid. A plurality of heating elements 19 is provided in thermal communication with the walls 20 of the reservoir 16. The heating elements are configured to provide thermal energy to a specific area of the reservoir 16 so that it is possible to control which portions of the material being pumped are melted. The walls 20 of the reservoir 16 are cooled by coolant 21. Coolant 21 is depicted as being in contact with just one wall 20 of the reservoir 16, but it will be appreciated that the path of the coolant 21 may differ from that depicted and may, for example, be in contact with more than one wall 20 of the reservoir 16. The coolant 21 may take a circuitous path through the pump 15 or indeed any path to provide the desired cooling effect. The figure depicts seven heating elements 19, but the invention is not particularly limited to this number of heating elements 19 and it will be appreciated that more or fewer heating elements 19 may be provided. The number of heaters can be selected on the basis of features, such as but not limited to, the thickness of the reservoir walls, the thermal conductivity of the material of the reservoir walls, and the length of the pump. The heating elements 19 may be connected to a controller (not shown) which is configured to operate the heating elements 19 in the desired order to provide a pumping output. The arrows within the liquid material 17 and within the solid material 18 indicate the direction of travel of the solid plug 18 and the liquid material 17, with the liquid material 17 moving from the low-pressure end 22 towards the high pressure end 23. It will be appreciated that the plug of solid material 18 is not an unchanging plug which passes through the reservoir 16, but is rather a zone of solid material that moves through the reservoir 16 by solidification of the material towards the low pressure end 22 and melting of material from towards the high-pressure end 23. For the sake of clarity, the heating elements 19 are depicted as solid when they are turned on and with a white centre when turned off in the figures.

Figure 3 depicts a pump 15 having a reservoir 16 which has a diameter change along its length. Figure 3 depicts an embodiment in which the reservoir 16 is tapered such that the portion of the reservoir 16 towards the high pressure end 23 is wider than towards the low pressure end 22. In this way, the solid portion 18 of the material being pumped, such as tin, is unable to be extruded along the reservoir 16 towards the low pressure end 22. The inner wall of the reservoir 16 may additionally or alternatively be threaded or include discrete cut outs.

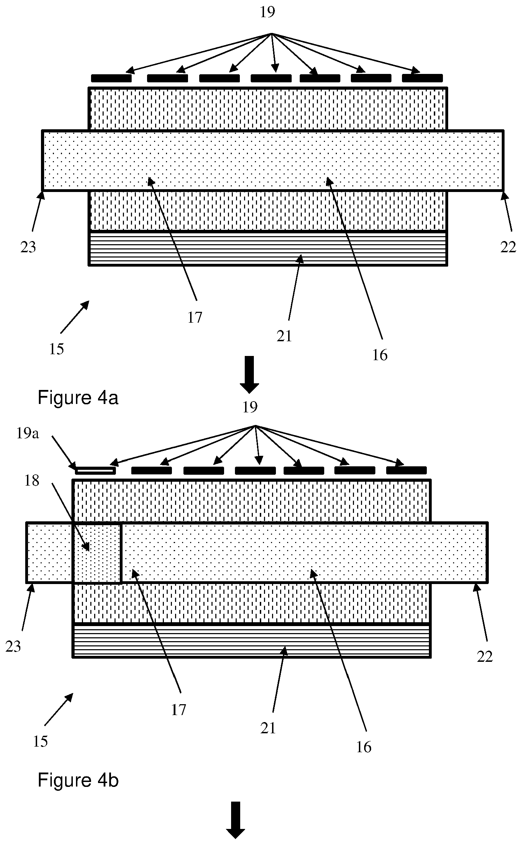

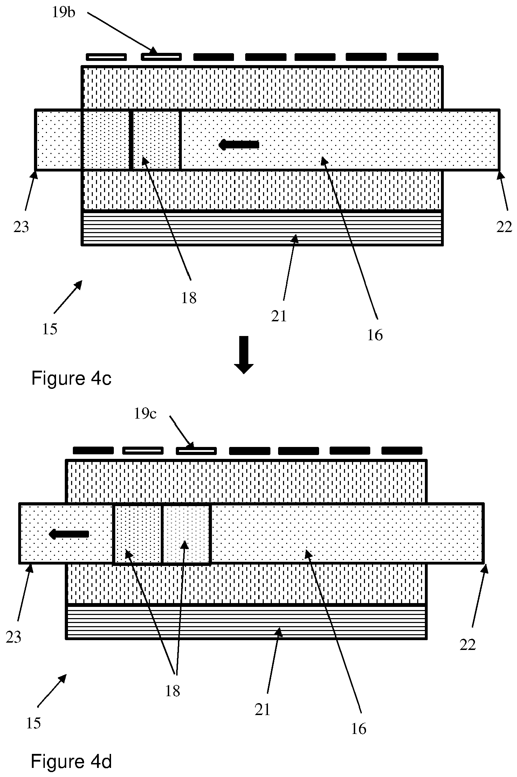

Figure 4 is series of cross-sections through the pump according to the present invention at different periods of time showing the pumping action of the pump 15. In Figure 4a, all of the heaters 19 are turned on such that the material within the reservoir 16 of the pump 15 is liquid. In Figure 4b, the first heater 19a has been turned off. As such a plug 18 is formed within the reservoir 16. Upon solidification, the material, for example tin, contracts which forms a plug 18 that inhibits any flow. Whilst contracting, liquid tin from both sides will be drawn in. In Figure 4c, the second heater 19b has been turned off to allow more material to solidify. Again, this solidification results in contraction of the tin, but since there is already a plug 18 of solid tin on one side, this solidification draws in liquid tin from the reservoir on the right (as depicted in the figure). As such, there is a movement of liquid tin from the low pressure end 22 towards the high pressure end 23 as shown by the arrow. In Figure 4d, the third heating element 19c has been turned off and the liquid tin allowed to solidify, again drawing in more liquid tin from towards the low-pressure end 22. Either simultaneously or after the third heating element 19c has been turned off and the third solid plug formed, the first heating element 19a is turned on. This causes the portion of the tin in thermal communication with the first heating element 19a to melt and thereby expand. Since there is a solid plug 18 upstream of this newly melted portion of tin, there is a net pressure increase towards the high pressure end 23 of the reservoir 16. This process can be continued with the controlled solidification and subsequent melting of the tin within the reservoir 16 to provide a net pumping action towards the high pressure end 23. It is appreciated that when the material in thermal communication with the first heater 19a is solidified, that material will be drawn in from both sides and cause a slight pressure drop at the high pressure end 23. However, since there are multiple heating zones, as the process of melting and expelling liquid towards the high pressure end 23 continues, there is a net pumping action towards the high pressure end 23. Whilst the melting and solidification steps are depicted and described as discrete steps, it should be appreciated that these steps could be simultaneous and the melting and solidification could continuously move along the reservoir 16, so as to provide a continuous output at the high pressure end 23.

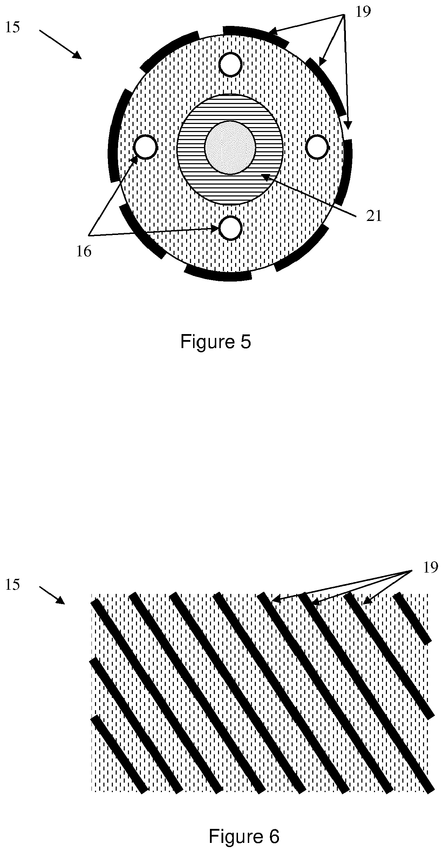

Figure 5 depicts a cross-section through a pump 15 according to the present invention comprising a plurality of reservoirs 16 (only two of which are numbered) which contain the material being pumped. As depicted, the reservoirs 16 may be formed as bores though a matrix, such as holes drilled through a metal, preferably a metal which is compatible with liquid tin.. Due to the very high pressures generated, the walls of the reservoirs 16 could deform and even burst, so it is desirable to have walls which are thick enough to withstand the high pressures involved. In embodiments where lower pressures are used, the reservoirs 16 may comprise sections of piping. It will be appreciated that reducing the cross sectional area of each reservoir reduces the surface area on which the pressure acts and so the stress on the reservoir is reduced. As such, multiple small reservoirs may be preferred over a single large reservoir. In the depicted embodiment, there are four reservoirs 16, but it should be appreciated that any number of reservoirs may be used and the invention is not particularly limited to the specific number of reservoirs. The coolant 21 is provided through the centre of the pump 15 to cool the material within the reservoirs 16. The heating elements 19 are disposed around the reservoirs 16 and configured to provide thermal energy to the material within the reservoirs 16.

Figure 6 depicts a side view of the pump 15. The heating elements 19 (only three are numbered) are helically wound around the pump 15. Each heating element 19 makes more than one complete rotation around the pump 15 such that when one of the heating elements 19 is deactivated, there is a corresponding solid plug of material within each reservoir 16. This prevents any loss of pressure from within the reservoirs 16 and provides added safety. The exact pitch of the heating elements 19 can be varied as required and the invention is not particularly limited by the pitch. Since there is a plurality of reservoirs 16, the output of the pump can be maintained more easily than would be the cases with a single reservoir 16.

The present invention provides a pump and method of pumping not previously known. The present invention eliminates the need for high pressure gas handling apparatus, which makes the system less complex. In addition, since in embodiments using materials which are solids at ambient temperature and pressure, the only working fluid is liquid tin or lithium, which are incompressible, there is a low amount of energy stored in the system so it is inherently safer than a gas-based high pressure system in which a large amount of energy is stored. As such, if there is a leak, only a very small amount of liquid, in the order of a few milliliters will be released, in contrast to leaks in high pressure gas systems where a leak can accelerate liquid metal to high speeds and release a lot of rapidly expanding gas. Furthermore, it is possible to release the pressure in the system rapidly by turning on all of the heating elements to melt the material within the pump and allow the pressure to equalize.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A pump comprising a reservoir and a plurality of heating elements in thermal communication with the reservoir, the plurality of heating elements configured to selectively provide thermal energy to the reservoir.

2. The pump according to claim 1, wherein the pump includes a source material within the reservoir.

3. The pump according to claim 2, wherein the source material is selected from either tin or lithium.

4. The pump according to any preceding claim, further comprising a controller configured to selectively operate the heating elements in a preselected order.

5. The pump according to any preceding claim wherein the reservoir has a diameter change along its length, preferably wherein the reservoir comprises an inner wall and said inner wall is threaded, tapered, tapered and threaded, or comprise discrete cut-outs in the inner wall.

6. The pump according to any preceding claim, wherein the pump further comprises a cooling mechanism.

7. The pump according to any preceding claim, wherein the pump includes a plurality of reservoirs.

8. The pump according to any preceding claim, wherein the plurality of heating elements are in the form of a helix around the reservoir, preferably wherein each heating element makes more than one turn around the reservoir.

9. The pump according to any of claims 4 to 8, wherein the controller is configured such at least one of the heating elements is turned off at any one time during operation.

10. The pump according to any preceding claim, wherein the pump is configured to provide up to 2, up to 5, or up to 10 milliliters per hour of high pressure liquid.

11. The pump according to any preceding claim, wherein the pump is configured to provide liquid at a pressure of 0.1 MPa, at least about 1 MPa, at least about 10 MPa, at least about 25 MPa, at least about 50 MPa, at least about 70 MPa, at least about 100 MPa, or from around 0.1 MPa to around 200 MPa.

12. The pump according to any preceding claim, said pump having a low pressure end in communication with a low pressure reservoir and a high pressure end in communication with a tin droplet generator.

13. A method of pumping a material, said method including the steps of:
a) providing a pump with a reservoir in thermal communication with an array of heating elements;
b) providing the material to be pumped in the reservoir;
c) operating the array of heating elements to melt the material in the reservoir;
d) operating the array of heating elements to allow a first portion of the liquid material to solidify thereby forming a plug;
e) operating the array of heating elements to allow an upstream second portion of the liquid material adjacent to the plug to solidify; and
f) operating the array of heating elements to melt a downstream portion of the plug to generate a portion of liquid material at increased pressure.

14. The method according to claim 13, said method further including the steps of:
g) operating the array of heating elements to allow a third portion of the liquid material upstream of and adjacent to the solidified second portion to solidify; and
h) operating the array of heating elements to melt the solidified second portion of the material: and
i) optionally repeating steps g) and h) with further upstream portions of the material.

15. The method according to Claim 13 or 14, wherein the method further includes cooling the reservoir to cool the melted material.

16. The method according to any of Claims 13 to 15, wherein the method further comprises controlling the array of heaters with a controller.

17. The method according to any of Claims 13 to 16, wherein the method further comprises connecting an output of the pump to a droplet generator apparatus, optionally further comprising connecting the droplet generator apparatus to a lithographic apparatus.

18. A sub-system for a lithographic apparatus, said sub-system comprising a droplet generator apparatus and a pump according to any of claims 1 to 12.

19. A radiation source comprising a pump according to any one of claims 1 to 12 or a sub-system according to claim 18, or operated in accordance with the method of any of claims 13 to 17.

20. A lithographic apparatus comprising a pump according to any one of claims 1 to 12 or a sub-system according to claim 18, or operated in accordance with the method of any of claims 13 to 17.

21. The use of a pump, method, sub-system, radiation source, or lithographic apparatus of any of claims 1 to 20 in a lithographic process.
